# EUROPEAN PATENT APPLICATION

(11) **EP 1 583 229 A1**
(43) Date of publication of application: **05.10.2005**
(21) Application number: 04300170.0
(22) Date of filing: 31.03.2004
(51) Int. Cl.: H03F 3/217, H03F 1/30, H05K 7/20

(54) **Circuit for controlling a cooling device**

(71) Applicant: Thomson Licensing, 92100 Boulogne Billancourt (FR)
(72) Inventor: Lee, Kok Joo, 538542 Singapore (SG); Tee, Chun Meng, 328714 Singapore (SG)
(74) Representative: Rossmanith, Manfred

(57) **Abstract**

A method for controlling a cooling device (7) for a switched power device, e.g., a digital amplifier, is presented. The method includes sensing the output signal (S) and adjusting the power of the cooling device (7) according to the output power of the switched power device. The invention eliminates the need for temperature sensors attached to the heat sink by recognizing that the heat generated in switched power devices is correlated to the output power.
Further, a circuit implementing the method and an amplifier using the inventive circuit is presented.

## Description

Modern audio and video amplifiers which have to provide a large amount of output power are often designed as digital amplifiers. Digital amplifiers, also referred to as switched amplifiers, generate an output signal by activating switches in a modulated manner. The switches supply a fixed voltage to the output when switched on. When switched off the switches do not supply a voltage to the output. The modulated output signal is often passed via a filter in order to remove high frequency components from the desired output signal. However, not all digital amplifiers need filtering at the output. Modulation of digital amplifiers may comprise modulation schemes such as pulse width modulation, often referred to as PWM, or pulse density modulation. However, other modulating schemes are conceivable. In order to comply with regulations concerning electro-magnetic radiation and compatibility, spread spectrum modulation schemes may be used. The digital amplifiers do not operate the output switches in the linear region. The switches used are predominantly transistor switches, most commonly bipolar or MOS-Fet transistors are used. There are, however, other semiconductor switches available which may also be used. By crossing the linear region of the output transistors very quickly during transition from on to off or vice versa very little power is wasted and transferred into heat, which has to be removed. For removing heat from electronic devices heat sinks are commonly used. Heat sinks are often made from aluminum or copper structures, which are in direct thermal contact to transistors or other heat generating sources. Passive heat sinks are often made of rather bulky structures of the afore-mentioned kind. Large heat sinks made from large amounts of aluminum or copper increase cost and weight. These heat sinks rely on radiation or natural air flows to build up due to the differences in temperature of the heat sink and environment. The natural air flow is often also referred to as free convection. In space critical applications or in applications where free convection may not always be ensured or sufficient, other cooling techniques are applied. These other cooling techniques include ventilators or fans, compressors and thermal electrical cooling devices. Thermal electrical cooling devices are commonly known as Peltier elements. Compressors may be used in conjunction with a heat pick up and a radiator. The compressors are used to circulate a cooling agent through the arrangement of heat pick up and radiator. Commonly known applications of compressors used for cooling are refrigerators.

In order to prevent the cooling devices from working when not necessary, the cooling devices are often regulated. Regulating cooling devices may increase the lifetime of the cooling devices itself but also prevents noise associated with the cooling device operating to be emitted when additional or forced cooling is not necessary. Further the waste of energy associated with a cooling device unnecessarily operating is avoided. The regulation of the cooling devices is often performed by sensing the temperature of the heat sink or the air flow transported away from the heat source. The sensors necessary for sensing the temperature increase cost of the device and further may introduce an additional source for failures or malfunctions. It is, therefore, desirable to increase the reliability of the regulation of cooling devices while reducing the amount of components. A further aspect is to provide an improved circuit for controlling a cooling device.

This objective is achieved by the inventive circuit as claimed in claim 1. Advantageous developments and embodiments are presented in the sub claims.

In the following specification a device providing an output signal which is derived from a switched modulated signal and which device is to be cooled is referred to as switched power device for the sake of clarity. In the inventive circuit for controlling a cooling device in a switched power device, a filter receives a signal which represents the switched modulated signal. The output signal of the filter is fed to a control input of a driver stage. The driver stage is controlling the cooling device in response to the filtered switched modulated signal. The driver stage may additionally have an input buffer to isolate the output of the filter stage from the load. The switched power device to be cooled in accordance with the invention may be a digital or switched amplifier. The switched power device may be used for amplifying audio or video signals. It is, however, conceivable to use switched power devices in accordance with the invention for other purposes such as motor drives or actuator drives. The invention is thus not limited to audio or video signals.

The invention advantageously makes use of the fact that switched power devices generate excess heat in response to the magnitude of the output signal. Most heat in switching power devices is generated during the transition of the switch from on to off and vice versa, and during the time the switch is conducting.

In the pulse width modulation scheme the conduction time is modulated in order to vary the output signal. The switching frequency may be fixed for this modulation scheme. In this modulation scheme the duty cycle of the switch, i.e. the ratio of on to off time, is determining the variable amount of heat that is generated, while the number of transitions is constant due to the constant switching frequency.

In the pulse density modulation scheme the pulse width may be fixed and the frequency of pulses is modulated. Here, the frequency of the pulses is determining the variable amount of heat that is generated. The on-time conduction losses are constant on a pulse-by-pulse basis. However, the number of pulses required to represent the desired output signal may be variable, and thus the amount of conduction losses overall may be variable, too.

Modulation schemes may not be used in their generic forms, but may also be combined. It is conceivable to use pulse density modulation for low output power levels and to switch to pulse width modulation for higher output power levels. It is also conceivable to directly combine the modulation of pulse width and pulse frequency.

In this specification the term switched modulated signal is used as a synonym for any modulation scheme for switched power devices in accordance with the invention.

Independent of the modulation scheme used cooling of switched power devices is often only required when large output signals are provided. As an example, this holds true for the conduction losses during the on-time of the switch. The conduction losses are often resistive losses related to the current value squared. When inductive filtering is used for filtering the output, the current will increase linearly until it reaches a maximum, given that no saturation of the filter inductor occurs. The longer the conduction time, the higher the current and the associated conduction losses. However, the requirement for cooling is dependent of the value of the output signal for the other modulation schemes as well, as was discussed before.

In order to acquire an information about the value of the output signal the inventive circuit feeds a signal representing the switched modulated signal to a filter. In a first embodiment of the invention the filter transforms the high frequency switched signal into a low frequency signal which is used to control a driver stage for the cooling device. The cooling device is thus provided in an advantageous manner with a uniform driving signal. Uniform driving signals which change rather slowly are preferred for controlling cooling devices in order to reduce noise that may be induced by frequent changes in the driving signal and high frequency harmonics superimposed on the control signal.

In an advantageous embodiment of the invention the circuit is adapted to control the cooling device to assume a first operating condition below a first level of the output signal of a filter stage. Further, the circuit controls the cooling device to assume a second operating condition above a second level of the output signal of the filter stage. Thirdly, the circuit controls the cooling device to assume a third operating condition between the first and the second level of the output signal of the filter stage.

The first operating condition may include driving the cooling device at a low level. The low level of drive supplied to the cooling devices causes little or virtually no noise created by the cooling device. In one exemplary embodiment of the inventive circuit the low level of drive is equivalent to an off state.

The second operating condition may include to drive the cooling device at a high level. In one exemplary embodiment of the invention the high level is equivalent to full power.

The third operating condition may comprise to drive the cooling device in response to the output signal of the switched power device. The characteristic of the response curve may, e.g., be linear. However, any other characteristic such as logarithmic, exponential or the like is applicable.

It is to be noted that a larger number of operating conditions is conceivable without leaving the scope of the invention, e.g., using discrete steps of power delivered to the cooling device according to the value of the output signal of the switched power device. It is also conceivable to sample a drive signal of the switching power device and to derive a control signal for the cooling device from the sampled drive signal. Filtering of the sampled drive signal may take place in the digital domain, or may, depending of the modulation scheme, be omitted. No conventional filtering may be, e.g., required for pulse density modulation scheme. In this case the number of drive pulses in a predetermined time interval is counted and the control information for the cooling device is derived therefrom.

The inventive circuit for controlling a cooling device is particularly advantageous when the switched power device is an audio amplifier. In this application the noise generated by the cooling device will be almost inaudible when the audio output signal is very small. When more audio output power is delivered the sound level in the listening environment will be increased. In this case the cooling device will operate at a higher level and may also generate audible noise. However, the audible noise generated in this operating condition will be masked by the audio signal.

Using a circuit for controlling a cooling device in this application advantageously allows for smaller heat sinks while at the same time provides a sufficient amount of cooling to the switched power device. Reducing the size of the heat sink allows for, besides the associated cost reduction, new shapes in the design of the switched power device.

In the following the invention will be described with reference to the drawing. In the drawing
Figure 1 shows a schematic block diagram of the inventive circuit;
Figure 2 shows a first exemplary diagram of the operating conditions;
Figure 3 shows a second exemplary diagram of the operating conditions; and
Figure 4 shows an exemplary embodiment of a circuit for controlling a cooling device according to the invention.

In the figures identical or similar elements are referenced by the same reference designators.

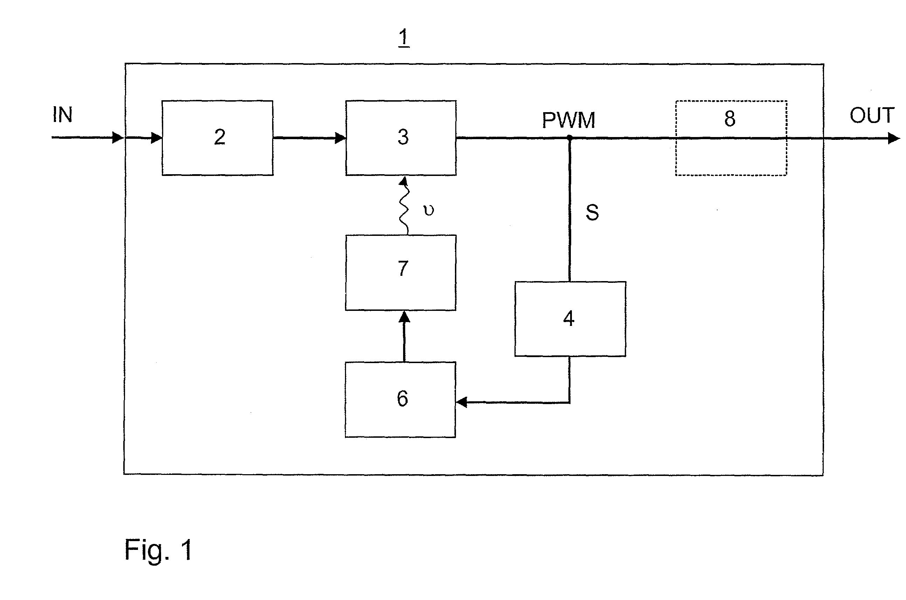

Figure 1. shows a schematic block diagram of the circuit for controlling a cooling device according to the invention. A switched power device 1 receives an input signal IN which is supplied to a signal receiving stage 2. The signal receiving stage may include a modulating stage. However, the modulation stage may also be included in a power stage 3. The input signal is passed from the signal receiving stage 2 to the power stage 3. The power stage 3 is designed as a switched power stage. The switched power stage 3 outputs the amplified signal at an output OUT. A filter stage 8 may be provided between the switched power stage 3 and the output OUT. Since the filter stage 8 is not always necessarily present it is shown in a dashed line. From the output from the switched power stage 3 a signal S is tapped and fed to a filter stage 4. The filter stage 4 filters the signal S and provides the filtered signal to a driver stage 6. The driver stage 6 controls a cooling device 7 in accordance with the output signal of the switched power stage 3. The cooling device 7 is thermally coupled to the switching power stage 3 in order to remove excess heat. Thermal coupling is indicated in the drawing by the Greek letter υ (theta). The signal S may be derived before or behind a filter 8, when provided. Further, the signal S may be conditioned before being provided to the filter 4. This conditioning may be necessary, e.g., if the level of the output signal, the level of the filter circuitry and the drive circuit are incompatible.

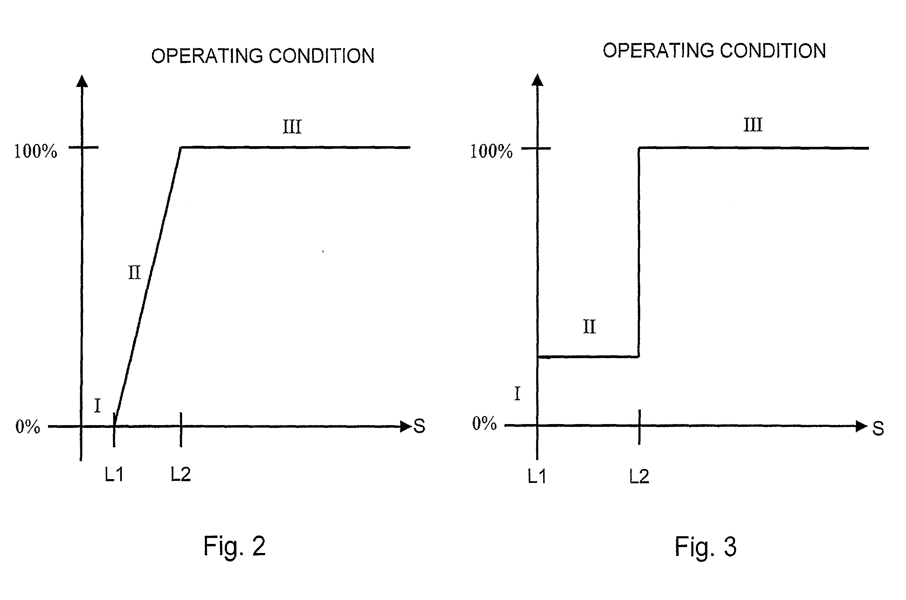

In Figure 2 different operating conditions of a cooling device controlled by a control circuit according to a first embodiment of the invention are shown. The operating condition is shown as a percentage level relative to full power of the cooling device on the axis of ordinates. The levels of the signal S are shown on the axis of abscissae. In the figure the cooling device is at zero percent of full power when the value of the signal S is below a first level L1. For values of the signal S between levels of L1 and L2 the power of the cooling device, i.e., the operating condition, proportionally follows the signal S. Since the signal S is representing the output signal OUT, the operating condition of the cooling device follows the output power of the switched power device. For levels of the signal S above a level L2 the cooling device is driven at 100% or full power. In this figure the first, second and third operating conditions I, II and III are clearly visible.

In Figure 3 different operating conditions of a cooling device controlled by a control circuit according to a second embodiment of the invention are shown. Similar to the diagram shown in Figure 2, the power of the cooling device and the levels of the signal S are shown on the axis of ordinates and abscissae, respectively. In Figure 3 the power of the cooling device is set to 25% for values of the signal S between a first level L1 and a second level L2. The power of the cooling device is set to 100% for levels of the signal S above the second level L2. In this exemplary embodiment of the invention the first operating condition I is covering only a very small range of the signal S, i.e., the first operating condition I is achieved only for the signal S being equal to zero. The second operating condition II is covering a rather large range of the value of the signal S: The second operating condition II, equivalent to full power, is achieved for all values of the signal S above the second level L2. The third operating condition III, the cooling device set to 25% of full power, is achieved for values of the signal S between the first level L1 and the second level L2.

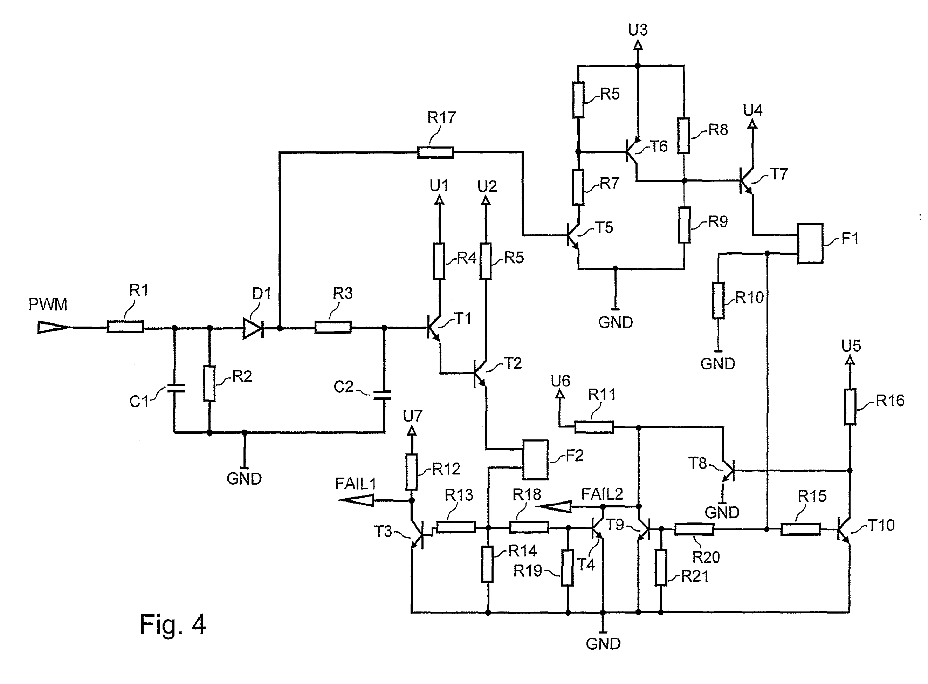

In Fig. 4 an exemplary embodiment of a circuit according to the invention is shown. A modulated output signal PWM is fed to a low pass filter including resistor R1 and capacitor C1. A resistor R2 is coupled in parallel to capacitor C1 for adjusting the time constant and the signal magnitude. The filtered signal is coupled via a diode D1 and a resistor R17 to a transistor T5. Transistor T5 operates as a simple comparator in conjunction with resistors R6 and R7 as well as transistor T6. Transistor T6 is coupled to the base electrode of transistor T7. The base electrode of transistor T7 is biased to a preset value by the voltage divider including resistors R8 and R9. When the signal PWM reaches a predetermined threshold, which is detected by the comparator including transistor T5, transistor T6 is switched on, bypassing resistor R8 of the voltage divider for biasing and driving transistor T7 into saturation. In this case, a cooling device F1 connected to transistor T7 will be operated at full power. The voltages U3 and U4 used to power this part of the inventive circuit may be equal in magnitude, or may even be connected. However, this is not essential for the inventive circuit to function. This part of the inventive circuit is designed to operate in a manner as described in respect of Figure 3.

The filtered signal PWM is further fed from the diode D1 to a second low pass filter including a resistor R3 and a capacitor C2. The output signal of the second low pass filter is connected to the base electrode of a transistor T1. The cathode of transistor T1 is connected to a first supply voltage U1 via a resistor R4. The transistor T1 acts as a buffer driver for a transistor T2, which is connected with its base electrode to the emitter electrode of transistor T1. The collector electrode of transistor T2 is connected to a second supply voltage U2 via a resistor R5. The emitter electrode of transistor T2 is connected to a cooling device F2. The driving voltage to the cooling device F2 is proportional to the filtered and rectified signal PWM. As the duty cycle of the signal PWM increases the signal at the emitter electrode of transistor T1 also increases resulting in increased power delivered to the cooling device. In one embodiment of the invention, the first and the second supply voltage U1, U2 are different in magnitude. In a preferred embodiment, the first supply voltage U1 is larger than the second supply voltage U2. When the voltage at the base electrode of transistor T2 approaches the second supply voltage U2 the transistor is driven to saturation and the maximum power is delivered to the cooling device. Transistor T1 provides sufficient base current drive to transistor T2 so that there is no loading of the filter and the signal PWM in the linear and saturation mode of transistor T2.

The inventive circuit shown in figure 4 further comprises additional circuitry for detecting failures of the cooling devices. The cooling devices F1, F2 are each connected to ground via sensing resistors R10 and R14, respectively. The base electrode of a transistor T3 is connected to the non-grounded contact of resistor R14 via a resistor R13. As soon as a current flows through the cooling device F2 a voltage builds-up across resistor R14 and transistor T3 will be conducting. The emitter electrode of transistor T3 is connected to ground, while the collector electrode of transistor T3 is connected to a supply voltage U7 via a resistor R12. A signal FAIL1 is derived from the collector electrode of transistor T3. During normal operation transistor T3 is conducting and the voltage at the collector electrode of transistor T3 is substantially zero. If cooling device F2 is open-circuit, transistor T3 will not conduct and the voltage at the collector electrode of transistor T3 will rise to the value of supply voltage U7. Since the cooling device F2 may be inoperative when very low output power is delivered by the switched power device the warning signal FAIL1 may be activated without an actual failure being present. However, using additional sensor inputs may help in detecting failure of the cooling device.

The non-grounded connection of resistor R14 is further connected to the base electrode of a transistor T4 via a resistor R18. A resistor R19 is connected to the base electrode of transistor T4 to form a voltage divider in connection with resistor R18. The emitter electrode of transistor T4 is connected to ground. When an excessive current flows through cooling device F2 the voltage at the base electrode of transistor T4 rises to a level which causes transistor T4 to conduct. The collector electrode of transistor T4 is connected to a supply voltage U6 via a resistor R11. In the case of an excessive current flowing through the cooling device F2 transistor T4 will conduct and the voltage of a warning signal FAIL2 that is present at the collector electrode of transistor T4 will be substantially zero.

A transistor T9 is connected to the cooling device F1 in a similar manner as transistor T4 is connected to the cooling device F2. Resistors R20 and R21 form a voltage divider connected to the base electrode of transistor T9. If the current through the cooling device F1 reaches excessive levels the voltage across resistor R10 increases, eventually, the transistor T9 will conduct and pull the warning signal FAIL2 to ground. Transistors T4 and T9 are connected in parallel with their collector electrodes. Cooling device F1 is further connected to a transistor T10 via a resistor R15. During normal operation of cooling device F1 transistor T10 will be conducting and the collector electrode of transistor T10, which is connected to a supply voltage U5 via a resistor R16 will assume substantially zero volts. The collector electrode of transistor T10 is connected to the base electrode of a transistor T8. The transistor T8 is connected in parallel to transistors T9 and T4 with its collector electrode. If cooling device F1 is open-circuit the voltage at the collector electrode of transistor T10 will rise to the supply voltage U5 and transistor T8 will start to conduct, thereby pulling low the warning signal FAIL2.

If either of the warning signals FAIL1 or FAIL2 is activated the user of the equipment may be informed and/or the power delivered by the switched power device may be limited to a safe value to prevent excessive temperature to build up and to prevent damage to the device.

The invention may be used in conjunction with all cooling devices listed in the description of the prior art and shall not be limited to fans or ventilators.

## Claims

1. Circuit for controlling a cooling device (7) in a device (1) providing an output signal (OUT) derived from a switched modulated signal (PWM), **characterized in that** a filter (4), receives a signal (S) representing the switched modulated signal (PWM), the output signal of the filter (4) is connected to a control input of a driver stage (6) and the driver stage (6) is controlling the cooling device (7) in response to the switched modulated signal (PWM).

2. Circuit according to claim 1, **characterized in that** the driver stage (6) is adapted to control the cooling device (7) to assume a first operating condition (I) below a first level (L1) of the output signal of the filter stage (4), to assume a second operating condition (II) above a second level (L2) of the output signal of the filter stage (4) and to assume a third operating condition (III) between the first and the second level (L1, L2) of the output signal of the filter stage (4).

3. Circuit according to claim 2, **characterized in that** the first, second and third operative conditions (I, II, III) include one of the list of conditions including inoperative, preset intermediate power, full power and substantially tracking the the output signal of the filter stage (4).

4. Circuit according to claim 1 or 2, **characterized in that** the driver stage (6) includes an input buffer and a driver.

5. Circuit according to any one of the preceding claims 1 to 4, **characterized in that** a detector circuit detects failure of the cooling device (F1, F2) and provides a failure indication signal (FAIL1, FAIL2).

6. Circuit according to claim 5, **characterized in that** the detector circuit includes a current and/or a voltage sensor.

7. Circuit according to claim 6, **characterized in that** the current sensor and/or the voltage sensor provide a signal substantially proportional to the drive power delivered to the cooling device (7).

8. Circuit according to claim 6, **characterized in that** a switching element including one of the list of transistors, optical switches, mechanical or micromechanical switches provides the output failure indication signal (FAIL1, FAIL2).

9. Circuit according to any one of the preceding claims 1 to 8, **characterized in that** the cooling device (7) is a fan, a compressor, a thermo-electric cooling device, or a combination thereof.

10. Amplifier for audio and/or video signals including a circuit according to any one or combination of claims 1 to 9.
